Europäisches Patentamt

(19) European Patent Office

Office européen des brevets

(11) Numéro de publication : **0 278 832 B1**

(12) **FASCICULE DE BREVET EUROPEEN**

(45) Date de publication du fascicule du brevet :
09.10.91 Bulletin 91/41

(51) Int. Cl.⁵ : **G11C 16/06, G11C 7/00, G06F 1/00**

(21) Numéro de dépôt : **88400162.9**

(22) Date de dépôt : **26.01.88**

(54) **Circuit de lecture pour mémoire.**

(30) Priorité : **27.01.87 FR 8700931**

(43) Date de publication de la demande :
**17.08.88 Bulletin 88/33**

(45) Mention de la délivrance du brevet :
**09.10.91 Bulletin 91/41**

(84) Etats contractants désignés :
**CH DE ES FR GB IT LI NL**

(56) Documents cités :
**US-A- 4 475 178**
**US-A- 4 545 038**

(73) Titulaire : **SGS-THOMSON MICROELECTRONICS S.A.**
**101 Boulevard Murat**
**F-75016 Paris (FR)**

(72) Inventeur : **Kowalski, Jacek Antoni**
**THOMSON-CSF SCPI 19, avenue de Messine**
**F-75008 Paris (FR)**

(74) Mandataire : **Ballot, Paul Denis Jacques et al**
**Cabinet Ballot-Schmit 7, rue le Sueur**
**F-75116 Paris (FR)**

EP 0 278 832 B1

Jouve, 18, rue Saint-Denis, 75001 PARIS

## Description

La présente invention concerne un circuit de lecture pour une mémoire telle qu'une mémoire non volatile programmable électriquement, de type EPROM ou EEPROM, ou toute autre mémoire comportant des cellules-mémoire dont la lecture est réalisée par détection d'une variation de courant ou de tension sur la ligne de bit.

Dans le cas, par exemple, des mémoires de type EPROM ou EEPROM, chaque élément de stockage d'informations ou cellule-mémoire est constitué par un transistor MOS à grille flottante qui peut être principalement de type FAMOS (pour floating gate avalanche injection MOS) ou de type SAMOS (pour stacked gate avalanche injection MOS). Ce type de transistor peut avoir deux états. Ainsi, dans le cas d'un transistor MOS à canal N, dans un premier état aucune charge ou une charge positive est piégée sur la grille flottante. Un canal de conduction peut exister entre source et drain. Le transistor conduit alors et se comporte comme un interrupteur fermé. Dans un deuxième état, des électrons sont piégés sur la grille flottante. Ils empêchent donc la création d'un canal de conduction dans le substrat entre source et drain. Dans ce cas, le transistor est bloqué et se comporte comme un interrupteur ouvert.

Pour programmer un transistor MOS à grille flottante, des tensions plus élevées que la tension de fonctionnement normale doivent être convenablement appliquées sur la grille de commande et l'une des électrodes de sorte que la grille flottante puisse absorber et garder une charge d'électrons. Cette charge d'électrons sur la grille flottante augmente le seuil de conduction sur la grille de commande du transistor. D'autre part, pour lire une mémoire ainsi programmée, une tension inférieure à la tension de seuil des transistors MOS à grille flottante programmés mais supérieure à la tension minimale des transistors non programmés, doit être appliquée sur la grille de commande. Cette tension de lecture permet de détecter l'état passant ou bloqué du transistor. En général, le transistor MOS à grille flottante est relié par une de ses électrodes à une ligne de bit polarisée en tension par un générateur. Son autre électrode est reliée à la masse ou à une tension basse. La ligne de bit est également connectée à un senseur de courant ou de tension. Ce senseur mesure le courant débité dans la ligne par le générateur. Ainsi, si la cellule-mémoire n'a pas été programmée, le transistor MOS à grille flottante est passant et lors de l'application d'une tension de lecture qui est supérieure à la tension de seuil des transistors non programmés, le transistor est mis en conduction. On détecte alors sur le senseur une variation de courant ou une chute de tension. Dans le deuxième cas, lorsque la cellule-mémoire a été programmée, les charges sont piégées sur la grille flottante du transistor. La tension de lecture appliquée sur la grille de commande est, dans ce cas, de sens opposé à la barrière de potentiel créée dans le canal de conduction par les charges stockées dans la grille flottante. Toutefois elle est insuffisante pour modifier la conduction du canal et le transistor reste bloqué. En conséquence, le senseur en bout de ligne de bit ne perçoit pas de variations de courant ou de tension.

Ainsi avec une mémoire de type EPROM telle que décrite ci-dessus, il est possible de lire le contenu d'une cellule-mémoire d'après la consommation du circuit, en particulier lorsque la mémoire est lue bit par bit.

Ceci est particulièrement gênant dans le cas des mémoires utilisées pour recevoir des informations confidentielles, car il est alors facile de détecter lors de la lecture, la teneur de ces informations.

La présente invention a pour but de remédier à cet inconvénient en proposant un circuit de lecture qui présente toujours une consommation de courant ou une variation de tension quel que soit l'état programmé ou non programmé de la cellule-mémoire lue.

En conséquence la présente invention a pour objet un circuit de lecture pour circuit intégré du type circuit logique comportant les caractéristiques de la revendication 1.

Selon un mode de réalisation préférentiel, les moyens permettant de décharger la ligne de bit sont constitués par la cellule-mémoire proprement dite et par un premier moyen formant interrupteur, connecté entre la ligne de bit et l'électrode reliée à la tension basse de la ou des cellules-mémoire, ce moyen étant fermé après la lecture.

D'autre part, les moyens retardant le moment de la décharge sont constitués par un condensateur et par un deuxième moyen formant interrupteur, tel qu'un transistor MOS, montés en parallèle entre l'électrode de la tension basse de la cellule-mémoire et la tension basse $V_{ss}$ ou la masse, le moyen formant interrupteur étant fermé une fois la décharge effectuée.

Pour permettre une décharge effective de la ligne de bit, la capacité utilisée dans les moyens retardant le moment de la décharge présente une valeur plus grande que la capacité de la ligne de bit de manière à pouvoir descendre la ligne de bit jusqu'à une tension proche de la tension basse $V_{ss}$. De préférence, cette capacité sera au moins égale à dix fois la capacité de la ligne de bit.

D'autres caractéristiques et avantages de la présente invention apparaîtront à la lecture de la description de divers modes de réalisations faite ci-après avec référence aux dessins ci-annexés dans lesquels :

— la figure 1 représente schématiquement une mémoire EPROM susceptible de recevoir la présente invention,

— la figure 2 représente schématiquement un circuit de lecture conforme à la présente invention ainsi qu'une cellule-mémoire d'une mémoire EPROM,

— la figure 3 représente un diagramme des temps des principaux signaux de commande du circuit de la figure 2,

— la figure 4 représente schématiquement une mémoire EPROM munie d'un circuit de lecture conforme à la présente invention.

Pour simplifier la description, dans les dessins les mêmes éléments portent les mêmes références. D'autre part la description a été faite en se référant à des circuits MOS réalisés en technologie C MOS, il est évident pour l'homme de l'art que la présente invention peut s'adapter à d'autres technologies, notamment à la technologie N MOS.

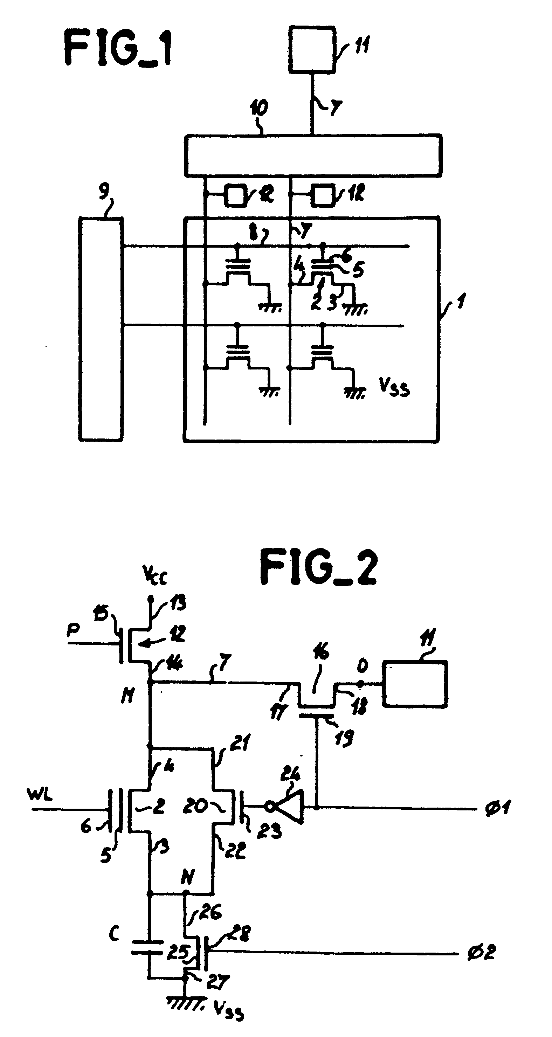

Sur la figure 1, on a représenté une mémoire 1 non volatile programmable électriquement de type EPROM. Cette mémoire est du type à cellule-mémoire constituée d'un transistor MOS 2 à grille flottante 5. De manière plus spécifique, le transistor 2 comporte deux électrodes principales respectivement 3 et 4, une grille flottante 5 et une grille de commande 6. Une première électrode principale, à savoir la source dans le mode de réalisation représenté, est reliée à une tension basse $V_{ss}$ ou à la masse tandis que l'autre électrode 4, à savoir le drain, est reliée à une ligne 7 appelée ligne de bit. La grille de commande 6 est reliée à une autre connexion 8 appelée ligne de mot. Les lignes de bit et lignes de mot sont disposées en ligne et en colonne pour déterminer une matrice incluant les cellules-mémoires, comme représenté sur la figure 1. Cette mémoire comporte des moyens constitués essentiellement par un décodeur de ligne 9 et un décodeur de colonne 10, pour appliquer sur les lignes et les colonnes des potentiels représentatifs d'informations à enregistrer dans les cellules-mémoire ou représentatifs de commande de lecture des informations enregistrées dans les cellules-mémoire. Ainsi, pour la lecture d'une cellule-mémoire, on fait monter la ligne de mot correspondante 8 à une tension produite par une sortie du décodeur de ligne 9. Au moyen du décodeur de colonne 10, on envoie sur la ligne de bit 7 l'état de la ligne de bit sélectionnée. Cette ligne de bit 7 a été au préalable préchargée à la tension d'alimentation $V_{cc}$ par l'intermédiaire d'un circuit de précharge 12. Le transistor MOS 2 devient passant ou reste bloqué selon que les charges ont été ou n'ont pas été au préalable piégées sur la grille flottante 5. Un circuit de détection 11 connecté par ailleurs à une extrémité de la ligne de bit 7 par l'intermédiaire du décodeur de colonne 10 formant multiplexeur, détecte la variation ou l'absence de variation de courant ou de tension. Il en déduit que la cellule-mémoire est programmée à "1" ou à "0" respectivement. Ainsi, avec ce type de mémoire, lors de la lecture, l'on observe ou l'on n'observe pas une consommation de courant suivant l'état de la cellule-mémoire. Comme mentionné dans l'introduction, ceci est particulièrement gênant dans le cas des mémoires lues bit à bit et contenant de plus des informations de type confidentiel.

On décrira maintenant avec référence à la figure 2, un mode de réalisation d'un circuit de lecture conforme à la présente invention permettant d'éviter les problèmes mentionnés ci-dessus.

Le circuit de lecture, conforme à la présente invention, comporte des moyens permettant, en mode lecture, de décharger la ligne de bit quel que soit l'état "1" ou "0" de cette cellule. Ces moyens sont constitués essentiellement par la cellule-mémoire 2 proprement dite et un transistor MOS 20 monté en parallèle sur la cellule-mémoire 2. De manière plus spécifique une des électrodes du transistor MOS 20, à savoir la source 22, est reliée à la source 3 de la cellule-mémoire 2 et l'autre électrode du transistor MOS 20, à savoir le drain 21 est connectée au drain 4 de la cellule-mémoire 2, ce drain étant relié à la ligne de bit 7. D'autre part, la grille 23 du transistor MOS 20 est reliée par l'intermédiaire d'un inverseur 24 à un signal Ø 1 de validation de la lecture.

D'autre part, avec le circuit de détection proprement dit est inclus un moyen permettant de mémoriser l'état lu. Ce moyen est constitué d'un transistor MOS 16 dont une des électrodes 18 est reliée au circuit de détection 11 et dont l'autre électrode 17 est connectée au noeud M de la ligne de bit 7. La grille 19 du transistor 16 reçoit le signal de validation d'écriture Ø 1 décrit ci-après. De plus, un circuit de précharge 12 de la ligne de bit est aussi connecté au noeud M. Ce circuit de précharge 12 est constitué d'un transistor MOS dont la source 14 est connectée au noeud M et dont le drain 13 est connecté à la tension d'alimentation $V_{cc}$. La grille de commande 15 reçoit un signal de précharge P permettant de précharger la ligne de bit 7 à la tension d'alimentation $V_{cc}$ avant la lecture de la cellule-mémoire 2.

Pour que la décharge de la ligne de bit soit, pour l'extérieur, réalisée au même moment quel que soit l'état "1" ou "0" de la cellule-mémoire, le circuit de lecture comporte de plus des moyens retardant le moment de la décharge. Ces moyens sont constitués essentiellement d'une capacité C montée en parallèle avec un moyen formant interrupteur 25 entre le noeud N commun aux sources 3 et 22 de la cellule-mémoire 2 et du transistor MOS 20 et la tension basse $V_{ss}$ ou la masse. La capacité C a pour but de stocker les charges obtenues lors de la décharge de la ligne de bit que cette décharge soit faite à travers la cellule-mémoire 2 lorsque celle-ci est programmée à "0" ou à travers le transistor MOS 20 rendu passant après la lecture de la cellule-mémoire 2 lorsque celle-ci est programmée à "1". Ultérieurement la capacité C sera déchargée lors de la fermeture du moyen formant interrupteur 25. Ce moyen formant interrupteur est constitué par un transistor MOS 25 dont une des électrodes 26 est connectée au noeud N, l'autre électrode 27 à la masse ou à la tension basse et dont la grille 28 reçoit un signal Ø 2 commandant la conduction ou la non-conduction du transistor MOS 20.

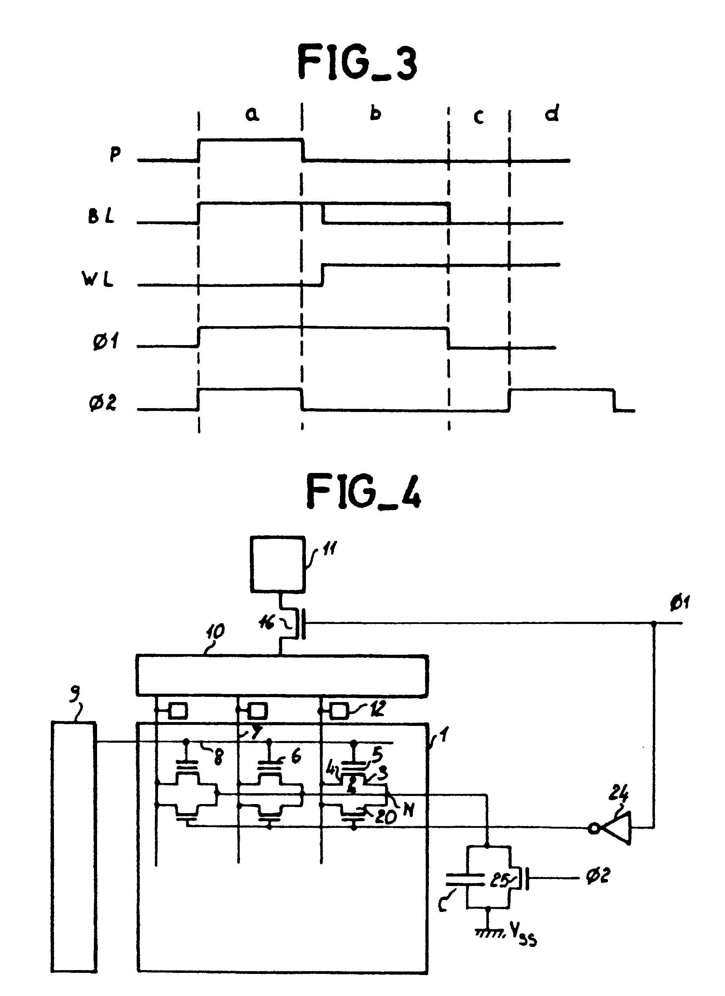

On expliquera maintenant, en se référant au diagramme des temps de la figure 3, le fonctionnement du circuit de lecture représenté à la figure 2. Ainsi pendant le temps a, le signal de précharge P et le signal Ø 2 sont positionnés au niveau logique "1".

De ce fait, on réalise la précharge de la ligne de bit 7 à la tension d'alimentation $V_{cc}$ comme représenté par le signal BL et la capacité C se décharge à travers le transistor MOS 25 rendu conducteur de manière que le noeud N se trouve à une tension sensiblement égale à la tension basse $V_{ss}$ ou masse. A la fin de cette période de précharge, les signaux P et Ø 2 repassent au niveau logique "0". Ensuite, pendant le temps b, on envoie sur la grille de commande 6 de la cellule-mémoire 2 un ordre de lecture WL, à savoir le signal WL passe au niveau logique "1". Si la cellule-mémoire 2 est programmée à "0", cette cellule conduit et la ligne de bit 7 se décharge dans la capacité C à travers la cellule-mémoire 2. Si au contraire la cellule-mémoire 2 est programmée à "1", la cellule-mémoire 2 est bloquée et dans ce cas la ligne de bit reste à la tension d'alimentation $V_{cc}$. Pendant les temps a et b, le signal de validation de lecture Ø 1 est positionné au niveau logique "1" de telle sorte que le transistor MOS 16 est passant. De ce fait, le noeud O entre le transistor MOS 16 et le circuit de détection 11 se trouve au niveau logique "1" ou au niveau logique "0" suivant l'état programmé ou non programmé de la cellule-mémoire. D'autre part, le transistor MOS 20 dont la grille 23 est commandée par le signal $\overline{Ø\,1}$, est bloqué.

Pendant le temps c, le signal Ø 1 passe au niveau logique "0" entraînant le blocage du transistor MOS 16 de telle sorte que le noeud 0 mémorise l'état de la cellule-mémoire détectée. Simultanément, le transistor MOS 20 devient passant et on réalise la décharge de la ligne de bit 7 dans la capacité C à travers le transistor 20 si la ligne de bit n'a pas déjà été déchargée à travers la cellule-mémoire 2. Pendant le temps d, le signal Ø 2 passe au niveau logique "1" de manière à réaliser la décharge de la capacité C à la tension $V_{ss}$ à travers le transistor MOS 25. En fait ce temps peut être éliminé et la décharge réalisée pendant la précharge de la ligne de bit. Dans ce cas, le signal Ø 2 peut être constitué par le signal de précharge P ou le signal de précharge P inversé suivant le type des transistors MOS 12 et 25 utilisés. Dans le mode de réalisation représenté, les transistors MOS 12 et 25 sont des transistors MOS de type N, toutefois il est évident pour l'homme de l'art que des transistors MOS de type P peuvent être utilisés pour les deux transistors 15 et 25 ou pour l'un ou l'autre de ces transistors. De même les transistors MOS 20 et 16 sont aussi constitués par des transistors MOS de type N mais des transistors MOS de type P peuvent aussi être utilisés.

La capacité C doit présenter une valeur relativement grande par rapport à la capacité de la ligne de bit 7 afin d'obtenir au noeud N une tension suffisamment basse pour pouvoir réaliser une décharge de la ligne de bit. De préférence, la valeur de la capacité C sera sensiblement au moins égale à 10 fois la valeur de la capacité de la ligne de bit. En effet après le partage des charges entre la capacité C et la capacité $C_{BL}$ de la ligne de bit, la tension au noeud N est égale à :

$$V_n = \frac{C_{BL}}{C + C_{BL}} V_{cc}$$

Si, C = $10 C_{BL}$ et $V_{cc}$ = 5 volts, on obtient donc :

$$V_n \simeq 0,45 \text{ volt}$$

D'autre part, le fait de décharger la ligne de bit dans la capacité C permet d'éviter une différence de temps pour le moment de la décharge de la ligne de bit selon que la ligne de bit se décharge à travers la cellule-mémoire ou à travers le transistor MOS 20, car le transistor 20 n'est rendu actif qu'une fois la lecture réalisée.

Sur la figure 4 on a représenté un circuit de lecture conforme à la présente invention appliqué à une matrice de cellules-mémoire.

Dans ce cas on remarque que les moyens retardant le moment de la décharge constituée par la capacité C et le transistor MOS 25 montés en parallèle entre le noeud N et la tension basse $V_{ss}$ sont commun à l'ensemble des cellules-mémoire commandées par une même ligne de mot 8 ou même à l'ensemble des cellules-mémoire de la matrice 1. D'autre part, comme représenté sur cette figure le transistor MOS 20 est monté entre la ligne de bit 7 et les noeuds N communs à l'ensemble des cellules-mémoire et l'ensemble des grilles des transistors 20 sont connectées par l'intermédiaire de l'inverseur 24 au signal Ø 1. De plus, le transistor MOS 16 est commun à l'ensemble des lignes de bit 7 et est positionné entre le circuit de détection 11 et le décodeur de colonne 10 formant multiplexeur. Le fonctionnement de ce circuit est identique au fonctionnement du circuit décrit avec référence à la figure 2.

La présente invention a été décrite en se référant à une mémoire EPROM, il est évident qu'elle peut s'appliquer à une mémoire EEPROM ou à toute mémoire dont les cellules-mémoire sont lues en préchargeant une ligne de bit et en détectant une variation de courant ou de tension sur cette ligne de bit.

**Revendications**

1. Circuit de lecture pour circuit intégré logique comportant une mémoire (1) constituée par une matrice de cellules mémoire (2), les cellules mémoire étant adressables chacune par des lignes et des colonnes sélectionnées par des décodeurs de ligne (9) et de colonne (10), le circuit de lecture étant relié aux cellules mémoire par une ligne appelée ligne de bit et comprenant un circuit de précharge (12) de la ligne de bit et un circuit de détection (11) détectant la décharge ou la non-décharge de la ligne de bit suivant l'état "0" ou "1" de la cellule mémoire sélectionnée et comportant un moyen (16) de mémorisation de l'état lu, caractérisé en ce qu'il comporte une capacité (C), et des moyens pour :

— dans un premier temps, décharger ou non la ligne de bit vers la capacité selon l'état de la cellule mémoire, et lire en conséquence cet état,

— dans un deuxième temps, isoler le circuit de détection de la ligne de bit et relier la ligne de bit à la capacité pour décharger la ligne de bit vers la capacité si elle ne l'a pas déjà été,

— dans un troisième temps, décharger la capacité.

2. Circuit de lecture selon la revendication 1, caractérisé en ce que les moyens permettant de décharger la ligne de bit sont constitués par la cellule mémoire (2) proprement dite et par un premier moyen formant interrupteur connectés entre la ligne de bit et la capacité.

3. Circuit de lecture selon la revendication 2, caractérisé en ce que le premier moyen formant interrupteur est commandé par un signal de validation de lecture inversé.

4. Circuit de lecture selon l'une des revendications 1 à 3, caractérisé en ce que la capacité est reliée entre la cellule mémoire et une tension basse Vss ou la masse.

5. Circuit de lecture selon l'une des revendications 1 à 4, caractérisé en ce qu'il est prévu un second moyen formant interrupteur en parallèle sur la capacité.

6. Circuit de lecture selon l'une des revendications 1 à 5, caractérisé en ce que la capacité (C) est au moins égale à dix fois la capacité de la ligne de bit.

7. Circuit de lecture selon l'une des revendications 2 ou 5, caractérisé en ce que les moyens formant interrupteur (16, 20, 25) sont constitués chacun par un transistor MOS dont la grille reçoit un signal de fermeture et d'ouverture.

8. Circuit de lecture selon l'une quelconque des revendications 1 à 7, caractérisé en ce que le circuit de précharge (12) est constitué par un transistor MOS dont une des électrodes est connectée à la ligne de bit, l'autre électrode à la tension d'alimentation et la grille à un signal de précharge permettant de précharger la ligne avant lecture.

9. Circuit de lecture selon l'une quelconque des revendications 1 à 8, caractérisé en ce que le moyen de mémorisation de l'état lu est constitué par un transistor MOS (16) connecté entre la ligne de bit (7) et le circuit de détection (11), permettant d'isoler le circuit de détection une fois la lecture effectuée, la grille du transistor MOS (16) étant commandée par le signal de validation de lecture.

**Patentansprüche**

1. Leseschaltung für integrierte Logikschaltung mit einem Speicher (1), der eine Matrix von Speicherzellen (2) umfaßt, wobei die Speicherzellen jeweils über von Zeilendekodierern (9) und von Spaltendekodierern (10) ausgewählte Zeilen bzw. Spalten adressierbar sind, wobei die Leseschaltung mit den Speicherzellen über eine Bitleitung genannte Leitung verbunden ist und eine Schaltung (12) zur Vorladung der Bitleitung und eine Erfassungschaltung (11), die die Entladung oder die Nichtentladung der Bitleitung entsprechend dem Zustand "0" oder "1" der gewählten Speicherzelle erfaßt, aufweist und ein Mittel (16) zum Speichern des gelesenen Zustandes enthält, dadurch gekennzeichnet, daß sie eine Kapazität (C) und Mittel zum :

— Entladen oder Nichtentladen der Bitleitung in Richtung der Kapazität gemäß dem Zustand der Speicherzelle und folglich zum Lesen dieses Zustandes in einem ersten Zeitpunkt,

— Isolieren der Erfassungschaltung von der Bitleitung und Verbinden der Bitleitung mit der Kapazität zum Entladen der Bitleitung in Richtung der Kapazität, wenn dies noch nicht geschehen ist, in einem zweiten Zeitpunkt, und

— Entladen der Kapazität in einem dritten Zeitpunkt enthält.

2. Leseschaltung gemäß Anspruch 1, dadurch gekennzeichnet, daß die Mittel, die die Entladung der Bitleitung ermöglichen, von der Speicherzelle (2) im engeren Sinne und von einem ersten, einen Unterbrecher bildenden Mittel, das zwischen die Bitleitung und die Kapazität geschaltet ist, gebildet werden.

3. Leseschaltung gemäß Anspruch 2, dadurch gekennzeichnet, daß das einen Unterbrecher bildende erste Mittel durch ein invertiertes Lesefreigabesignal gesteuert wird.

4. Leseschaltung gemäß einem der Ansprüche 1 bis 3, dadurch gekennzeichnet, daß die Kapazität zwischen die Speicherzelle und eine untere Spannung Vss oder Masse geschaltet ist.

5. Leseschaltung gemäß einem der Ansprüche 1 bis 4, dadurch gekennzeichnet, daß sie mit einem parallel zur Kapazität geschalteten und einen Unterbrecher bildenden zweiten Mittel versehen ist.

6. Leseschaltung gemäß einem der Ansprüche 1 bis 5, dadurch gekennzeichnet, daß die Kapazität (C) wenigstens gleich dem Zehnfachen der Kapazität der Bitleitung ist.

7. Leseschaltung gemäß einem der Ansprüche 2 oder 5, dadurch gekennzeichnet, daß die den Unterbrecher bildenden Mittel (16, 20, 25) jeweils durch einen MOS-Transistor gebildet werden, dessen Gate ein Sperr- und Öffnungssignal empfängt.

8. Leseschaltung gemäß einem der Ansprüche 1 bis 7, dadurch gekennzeichnet, daß die Vorladungsschaltung (12) durch einen MOS-Transistor gebildet wird, dessen eine Elektrode mit der Bitleitung, dessen andere Elektrode mit der Versorgungsspannung und dessen Gate mit einem Vorladungssignal, das die Vorladung der Leitung vor dem Lesevorgang erlaubt, verbunden sind.

9. Leseschaltung gemäß einem der Ansprüche 1 bis 8, dadurch gekennzeichnet, daß das Mittel zan Speichern des gelesenen Zustandes durch einen MOS-Transistor (16) gebildet wird, der zwischen die Bitleitung (7) und die Erfassungschaltung (11) geschaltet ist und die Isolation der Erfassungsschaltung bei einmal ausgeführtem Lesevorgang ermöglicht, wobei das Gate des MOS-Transistors (16) durch das Lesefreigabesignal gesteuert wird.

## Claims

1. A read circuit for an integrated logic circuit comprising a memory (1) constituted by a matrix of memory cells (2), said memory cells being each able to be addressed by lines and by columns selected by line and column decoders (9 and, respectively, 10), the read circuit being connected with the memory cells by a bit line and comprising a precharge circuit (12) for the bit line and a detection circuit (11) for detecting the discharge or the non-discharge of the bit line in accordance with "0" or "1 " condition of the selected memory cell and comprising means (16) for storing the read condition, characterized in that it comprises a capacitance (C) and means for :
   — in a first period of time, discharging or not discharging the bit line into the capacitance in accordance with the condition of the memory cell and consequently reading such condition,
   — in a second period of time, isolating the bit line detecting circuit and connecting the bit line with the capacitance in order to discharge the bit line into the capacitance if this has not already been done,
   — in a third period of time, discharging the capacitance.

2. The read circuit as claimed in claim 1, characterized in that the means for the discharge of the bit line are constituted by the memory cell (2) in the strict sense and by a first means constituting a switch, and the same are connected between the bit line and the capacitance.

3. The read circuit as claimed in claim 2, characterized in that the first means constituting the switch is controlled by an inverted read enabling signal.

4. The read circuit as claimed in any one of the preceding claims 1 through 3, characterized in that the capacitance is connected between the memory cell and low voltage Vss or ground.

5. The read circuit as claimed in any one of the preceding claims 1 through 4, characterized in that it is provided with a second means forming a switch in parallel with the capacitance.

6. The read circuit as claimed in any one of the preceding claims 1 through 5, characterized in that the capacitance (C) has a value equal to at least ten times the value of the capacitance of the bit line.

7. The read circuit as claimed in claim 2 or claim 5, characterized in that the means constituting the switch (16, 20 and 25) are each in the form of an MOS transistor whose gate receives an off and on signal.

8. The read circuit as claimed in any one of the preceding claims 1 through 7, characterized in that the precharge circuit (12) is constituted by an MOS transistor whose one electrode is connected with the bit line, the other electrode is connected with the supply voltage and the gate is connected with a precharge signal making it possible to precharge the line prior to reading.

9. The read circuit as claimed in any one of the preceding claims 1 through 8, characterized in that the means for storing the read condition is constituted by an MOS transistor (16) connected between the bit line (7) and the detection circuit (11) so as to permit the isolation of the detection circuit once reading has been performed, the gate of the MOS transistor (16) being controlled by the read enable signal.

EP 0 278 832 B1

# FIG_1

# FIG_2

7

# FIG_3

# FIG_4